# DEMANDE DE BREVET EUROPEEN

(11) **EP 0 629 759 A1**
(43) Date de publication de la demande: **21.12.1994**
(21) Numéro de dépôt: 94109338.7
(22) Date de dépôt: 17.06.1994
(51) Int. Cl.: E05B 49/00

(54) **Système de télécommande à plusieurs portées fonctionnelles**

(30) Priorité: 21.06.1993 FR 9307480
(71) Demandeur: VALEO ELECTRONIQUE, 94000 Creteil (FR)
(72) Inventeur: Boschini, Alain, F-92000 Nanterre (FR)
(74) Mandataire: Gamonal, Didier

(57) **Abrégé**

La présente invention concerne le domaine des systèmes de télécommande, pour le contrôle d'accès à un véhicule automobile notamment.

Selon l'invention, le module récepteur comporte un moyen de sélection des messages émis par un émetteur (30) en fonction de la zone (D1,D2) dans laquelle se trouve ce dernier. Si le module récepteur détecte que la fonction commandée par l'émetteur est autorisée pour la zone où l'émetteur se trouve, un moyen de sélection autorise le traitement de la commande.

## Description

La présente invention concerne le domaine des systèmes de télécommande, pour le contrôle d'accès à un véhicule automobile notamment.

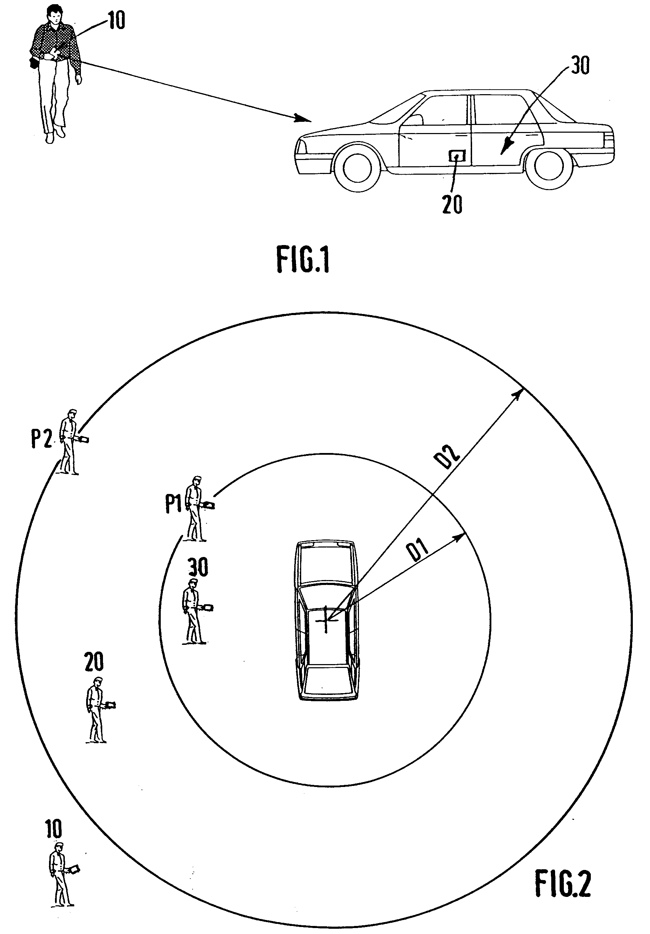

Les systèmes de télécommande connus comprennent généralement, comme représenté schématiquement figure 1, un émetteur portatif 10 et un récepteur 20 embarqué sur un véhicule 30.

L'émetteur 10 est conçu pour générer une onde codée, comme une onde électromagnétique codée. On entend par onde codée une onde porteuse d'une information de commande ou de signalisation dénommée "code".

Le récepteur 20 est conçu pour détecter l'onde électromagnétique codée générée par l'émetteur et décoder celle-ci.

Lorsque le code généré par l'émetteur 10 correspond à au moins un parmi plusieurs codes prédéterminés, le récepteur produit une commande qui agit sur un organe correspondant comme le contrôle du verrouillage/déverrouillage des portières du véhicule 30 ou des organes auxiliaires du véhicule.

Les systèmes de télécommande à transmission radioélectrique sont d'un emploi très souple dans la mesure, d'une part, où l'usager n'a pas besoin d'orienter l'émetteur vers le véhicule pour que la transmission soit établie et d'autre part, que la transmission puisse être établie à une distance de plusieurs dizaines de mètres du véhicule.

Ces systèmes de télécommande à transmission radioélectrique présentent par contre l'inconvénient d'avoir une portée de transmission sur véhicule affectée d'une dispersion et d'une variabilité dues, d'une part, à la dispersion des paramètres de construction de l'émetteur et du récepteur.

Ces paramètres de construction sont notamment :
- le niveau électromagnétique rayonné par l'émetteur,
- la sensibilité du récepteur à l'onde émise d'une part, et d'autre part, à l'influence de l'environnement ;
- le niveau de bruit électromagnétique environnant,
- la présence de matériaux électromagnétiques réfléchissants ou absorbants dans l'environnement proche du véhicule.

Ces dispersions et variabilités de la portée de transmission imposent au constructeur une limitation volontaire de la portée de transmission du système afin de garantir la conformité du système vis-à-vis des normes de sécurité internationales qui imposent des distances maximales de commande à distance de certaines fonctions de commande à distance.

La commande à distance de la fermeture des vitres sur véhicule est par exemple limitée, par les normes de sécurité américaines, à vingt pieds (environ six mètres).

Le confort d'usage des autres fonctions dont la distance maximale de commande autorisée est supérieure ou est non limitée se trouve par conséquent fortement dégradé.

Les mêmes inconvénients sont supportés par d'autres types de transmission comme les infrarouges, les ultrasons, les hyperfréquences, la lumière, etc... .

L'objet de la présente invention est donc de perfectionner ces systèmes et de permettre ainsi l'utilisation de davantages de fonctions télécommandées à partir de l'émetteur tout en respectant les normes de sécurité internationales et en conservant une bonne maîtrise de la portée de transmission.

En effet, l'invention concerne un système de télécommande et/ou de contrôle d'accès à distance utilisant au moins un émetteur et un récepteur qui échangent une onde porteuse pour transmettre des messages.

L'invention se caractérise en ce que le système de télécommande comporte un moyen pour sélectionner les messages reçus en fonction de la portée d'émission selon des critères préenregistrés.

Selon un aspect de l'invention, le système comporte un moyen de mesure de niveau du signal reçu par le récepteur sur l'antenne HF du module récepteur dans le cas d'un système de transmission radiofréquence. Etant considéré que le niveau HF reçu sur l'antenne est inversement proportionnel à la distance entre l'émetteur et le récepteur, il est ainsi possible de déterminer la distance à laquelle se trouve l'émetteur du véhicule.

Selon un autre aspect de l'invention, afin de s'affranchir des dispersions inhérentes aux paramètres de contruction de l'émetteur et du module récepteur et également afin de prendre en compte l'influence de l'environnement du véhicule, il est procédé sur véhicule à une phase de calibration des portées de transmission avant la mise en service du système.

D'autres caractéristiques et avantages de l'invention seront mieux compris à l'aide de la description qui suit et des dessins annexés quit sont :
- la figure 1 : la représentation d'un système de transmission décrit plus haut ;
- la figure 2 : une vue schématique des zones fonctionnelles de transmission sur véhicule ;
- la figure 3 : une vue schématique sous forme de blocs diagrammes fonctionnels d'un mode préféré de réalisation du système de télécommande conforme à la présente invention ;
- la figure 4 : un mode de réalisation du format des données transmises par l'émetteur ;
- la figure 5 : un mode de calibration de la portée de transmission sur véhicule ;
- la figure 6 : un chronogramme de fonctionnement de l'émetteur et du récepteur.

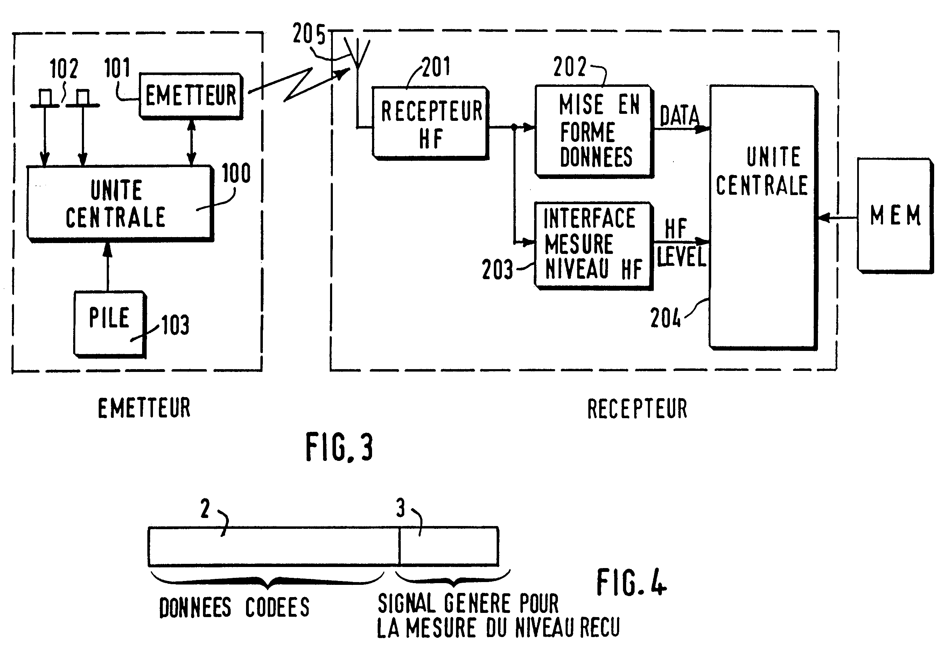

Comme représenté sur la figure 3, l'émetteur comporte une unité centrale 100 connectée à un émetteur radio-électrique 101 et à un ensemble de touches 102 de fonctions F1, F2, ... . L'unité centrale 100 est connectée à un ensemble d'alimentation par piles 103.

Le module récepteur comporte un récepteur radio-électrique 201 connecté à une antenne HF 205 et produisant un signal de réception pour un circuit de mise en forme des données 202 et pour un circuit de génération d'une valeur de mesure du niveau du signal reçu 203.

Les sorties des circuits 202 et 203 sont transmises à une unité centrale 204.

A chacune des activations d'une touche ou d'une combinaison de touches 102 de l'émetteur, l'unité centrale 100 génère un message de données composé comme indiqué sur la figure 4 d'une partie de données codées 2 et d'une partie 3 de données destinées à permettre la mesure du niveau reçu par le module récepteur. Ces deux parties du message sont produites successivement dans le temps en deux phases d'émission.

Dans un mode préféré de réalisation, la partie de données, destinée à permettre la mesure du niveau reçu par le module récepteur, est constituée par la porteuse pure à laquelle on n'applique aucune modulation. La période d'émission de cette partie 3 de données est prédéterminée et son début est en relation avec l'appui sur la touche de fonction de commande associée.

Le récepteur HF 201 transmet au circuit de mise en forme 202 un signal représentatif du message émis par l'émetteur. Le circuit de mise en forme des données 202 transmet à l'unité centrale 204 un signal logique DATA de données adapté à la technique d'acquisition et le décodage des données du message mises en oeuvre dans l'unité centrale 204. Le circuit de génération du signal de mesure de niveau HF 203 transmet à l'unité centrale 204 un signal analogique représentatif du niveau HF reçu sur l'antenne HF 205.

La phase de calibration commence par le placement de l'émetteur en position P1 (voir figure 2).

Cette position P1 correspond à une distance de référence D1 liée à la portée maximale autorisée pour les fonctions F1i. Pour chaque zone fonctionnelle, on répète l'opération de calibration. Le système comporte à cette fin un moyen pour entrer l'information de position d'où émet l'émetteur connecté à un moyen de calcul du récepteur. Le moyen de calcul du récepteur inscrit séquentiellement dans une mémoire de portées fonctionnelles admissibles la succession des valeurs mesurées par le moyen qui produit un signal représentatif de la puissance rayonnée de l'émetteur, ce dernier étant placé à la distance autorisée pour la fonction de la commande produit par l'émetteur, à cette distance.

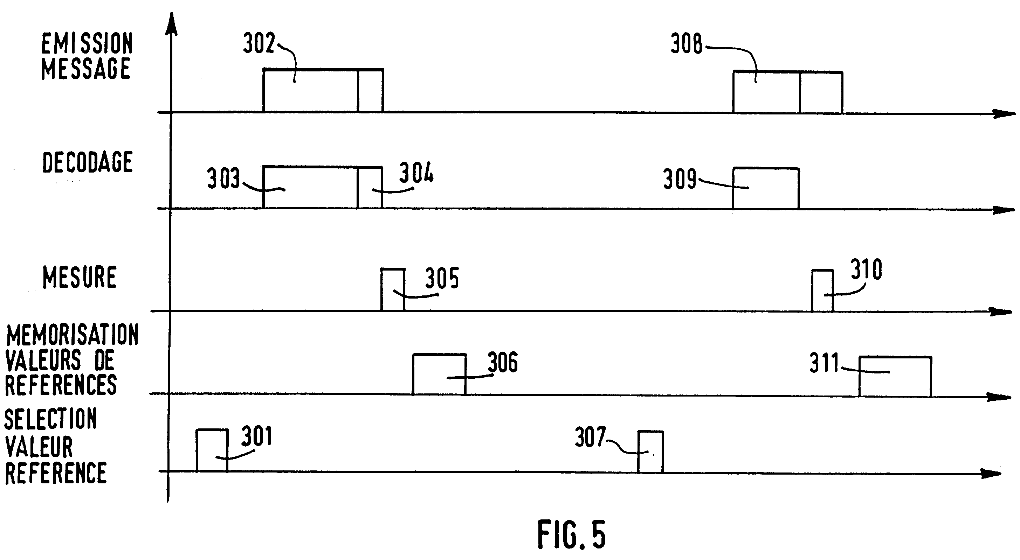

Le processus de calibration s'effectue dans l'ordre suivant (voir chronogramme figure 5) :
301 _ l'information de position de l'émetteur est transmise à l'unité centrale 204 du module récepteur par une liaison série ou par tout autre dispositif équivalent (interrupteurs, roues codeuses, etc.).
302 _ l'un des boutons-poussoirs de l'émetteur, correspondant à une fonction Fi dont la portée maximale autorisée est égale à D1, est activé et le message dont la partie de données codées correspond à cette touche F1i est transmis.
303 _ l'unité centrale 204 du module récepteur acquiert les données démodulées par le récepteur 201.
304 _ l'unité centrale 204 du module récepteur décode les données acquises. L'unité centrale 204 peut alors détecter que la touche activée par l'émetteur correspond à une fonction Fi donnée et sélectionner une adresse convenable dans une mémoire de portées fonctionnelles admissibles Di.
305 _ l'unité centrale 204 du module récepteur réalise la mesure du niveau NA reçu par l'antenne HF, à l'aide du circuit de génération d'une valeur de mesure du niveau du signal reçu.
306 _ l'unité centrale 204 du module récepteur mémorise la valeur mesurée NA précédemment comme la valeur de référence VR1 liée à la distance de référence D1.

Ce processus est répété autant de fois que le système de transmission admet de portées maximales autorisées.

L'unité centrale 204 permet ainsi de mémoriser dans une mémoire non volatile, EEPROM ou flash, un ensemble de valeurs de références VRk, chacune associée à la portée maximale autorisée Dk pour un groupe de fonctions (de commandes) donné Fki.

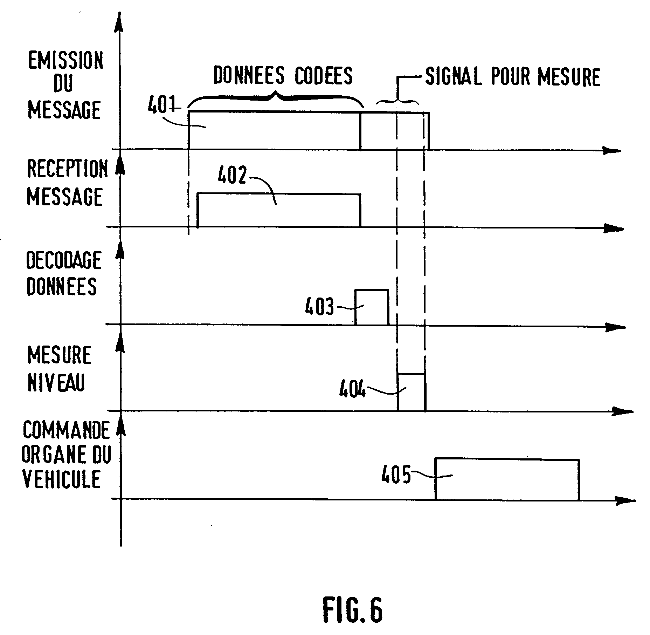

En utilisation habituelle, comme il est représenté sur la figure 6, le module récepteur active diverses taches afin d'une part de déterminer la validité du message reçu et d'autre part de mesurer le niveau du signal reçu sur l'antenne HF 205 :
401 _ l'un des boutons-poussoirs de l'émetteur est activé et le message HF est transmis.
402 _ l'unité centrale 204 du module récepteur acquiert les données démodulées par le récepteur 201 et transmises par le circuit de mise en forme 202 (signal DATA).
403 _ l'unité centrale 204 du module récepteur décode les données acquises.
404 _ si l'unité centrale 204 du module récepteur considére les données valides, à l'aide du circuit de génération d'une valeur de mesure de la puissance rayonnée par l'émetteur et reçue par le récepteur, elle réalise la mesure analogique du signal HFLEVEL représentatif du niveau HF reçu sur l'antenne HF.

L'unité centrale détermine la distance à laquelle se trouve l'émetteur du véhicule, puis compare la valeur du niveau du signal reçu aux valeurs de référence mémorisées lors de la phase de calibration.

Si le niveau reçu est inférieur à la valeur de référence 2 correspondant à la distance D2, l'unité centrale considère que l'émetteur est au-delà de la distance de référence 2.

Si le niveau reçu est supérieur à la valeur de référence 2 correspondant à la distance D2 et inférieure à la valeur de référence 1 correspondant à la distance D1, l'unité centrale considère que l'émetteur est situé dans une zone comprise entre la distance de référence 1 et la distance de référence 2.

Si le niveau reçu est supérieur à la valeur de référence 1 correspondant à la distance D1, l'unité centrale considère que l'émetteur est en deçà de la distance de référence 1.
405 _ en fonction de la zone où l'émetteur a été détecté, l'unité centrale 204 du module récepteur sélectionne la fonction à activer ou n'active pas la fonction demandée si l'émetteur est à une distance supérieure à la distance maximale autorisée pour la fonction correspondante.

Pour atteindre ces objets, le module récepteur comporte un moyen pour sélectionner les messages reçus en fonction de la portée d'émission selon des critères prédéterminés. Notamment, si le moyen de sélection détecte que la fonction commandée par le message reçu n'est pas une fonction autorisée Fi pour la zone Di où se trouve l'émetteur dont il a reconnu la position, le moyen de sélection ne sélectionne pas le message, le processeur 204 ne poursuivant pas l'exploitation du message reçu.

Le moyen de sélection selon l'invention comporte un moyen de contrôle par limitation de la puissance reçue de l'émetteur. En pratique, le moyen de contrôle ne réduit pas la valeur physique de la puissance reçue, mais en fonction de la valeur réellement mesurée détermine si celle-ci correspond à une position autorisée de l'émetteur dans une zone fonctionnelle associée à une fonction déterminée du système.

Dans un exemple de réalisation, la commande de l'allumage du plafonnier de l'habitacle du véhicule est autorisée à plus de 10 mètres, alors que celle du déverrouillage des portières n'est autorisée qu'à une portée plus réduite comme 2 mètres.

## Revendications

1. Système de télécommande et/ou de contrôle d'accès à distance comportant au moins un émetteur et un récepteur qui échangent une onde porteuse pour transmettre des messages, caractérisé en ce qu'il comporte aussi un moyen de sélection des messages reçus, ledit moyen de sélection comportant un moyen de mesure de la puissance reçue de l'émetteur de façon à ne sélectionner que les messages issus de l'émetteur dans une zone fonctionnelle associée à une fonction déterminée du système.

2. Système selon la revendication 1, caractérisé en ce que le récepteur comporte un moyen de détection et de démodulation de l'onde porteuse, connecté à un moyen de mise en forme du signal qui produit un signal d'information représentatif de la puissance rayonnée par l'émetteur et reçue par le récepteur.

3. Système selon la revendication 2, caractérisé en ce que le signal représentatif de la puissance rayonnée par l'émetteur est constitué par une période (B) d'émission de la porteuse sans modulation.

4. Système selon la revendication 3, caractérisé en ce que la période d'émission est activée par la commande de l'utilisateur comme l'enfoncement d'au moins une touche de commande de l'émetteur.

5. Système selon la revendication 4, caractérisé en ce que le récepteur comporte un moyen d'autorisation de l'éxécution de la commande reçue qui compare le signal produit par le moyen qui produit un signal représentatif de la puissance rayonnée par l'émetteur à une liste préenregistrée de valeurs correspondant à des zones fonctionnelles de sorte que le moyen d'autorisation produit un signal d'autorisation si le signal représentatif de la puissance rayonnée par l'émetteur correspond à une valeur préenregistrée associée avec la commande demandée par l'utilisateur.

6. Système selon la revendication 1, caractérisé en ce que dans une phase de calibration précédant au moins la première phase de l'utilisation, pour calibrer les portées fonctionnelles admissibles de l'émetteur, le système comporte un moyen pour entrer l'information de position d'où émet l'émetteur connecté à un moyen de calcul du récepteur, en ce que le moyen de calcul du récepteur inscrit séquentiellement dans une mémoire de portées fonctionnelles admissibles la succession des valeurs mesurées par le moyen qui produit un signal représentatif de la puissance rayonnée de l'émetteur, ce dernier étant placé à la distance autorisée pour la fonction de la commande produite par l'émetteur, à cette distance.
